# EUROPEAN PATENT APPLICATION

(11) **EP 2 530 706 A1**
(43) Date of publication of application: **05.12.2012**
(21) Application number: 11736936.3
(22) Date of filing: 21.01.2011
(51) Int. Cl.: H01L 21/304, B24B 37/00, C09K 3/14

(54) **METHOD FOR RECLAIMING SEMICONDUCTOR WAFER AND POLISHING COMPOSITION**

(30) Priority: 29.01.2010 JP 2010017742
(71) Applicant: Fujimi Incorporated, Kiyosu-shi, Aichi 452-8502 (JP)
(72) Inventor: MORINAGA, Hitoshi, Kiyosu-shi Aichi 452-8502 (JP); ASAI, Maiko, Kiyosu-shi Aichi 452-8502 (JP)
(74) Representative: Neuefeind, Regina
(86) International application number: PCT/JP2011/051090
(87) International publication number: WO 2011/093223

(57) **Abstract**

Provided is a polishing composition used for polishing a semiconductor wafer surface having a step in order to planarize the wafer surface and thereby reclaiming the semiconductor wafer. The polishing composition contains at least a step eliminating agent, which is adsorbed to the surface of the semiconductor wafer and acts to prevent etching of bottom portion of the step on the wafer surface during polishing. The step eliminating agent is, for example, a water-soluble polymer or a surfactant, and more specifically, a polyvinyl alcohol, a polyvinyl pyrrolidone, a polyethylene glycol, a cellulose, a carboxylic acid surfactant, a sulfonic acid surfactant, a phosphate ester surfactant, or an oxyalkylene polymer.

## Description

### TECHNICAL FIELD

The present invention relates to a method for reclaiming wafers that is carried out in order to reuse semiconductor wafers such as used test wafers and wafers having scratches on the surface. The invention also relates to a polishing composition for use in such a method.

### BACKGROUND ART

Semiconductor devices are fabricated by carrying out numerous operations such as film formation, exposure, etching, polishing, and cleaning on a substrate wafer such as a silicon wafer. In semiconductor device fabrication, large numbers of test wafers are used to monitor the state of each of these operations and investigate the conditions for the respective operations. The used test wafers are generally subjected to reclamation treatment for the purpose of reuse.

In addition, wafers that, for various reasons such as the presence of scratches on the surface, have been rejected in semiconductor device fabrication operations are sometimes subj ected to reclamation treatment.

In the reclamation of used semiconductor wafers, conventional practice has been to etch the used semiconductor wafer so as to remove any films present thereon, then to lap and/or grind the surface of the semiconductor wafer and subsequently planarize the wafer surface by chemical mechanical polishing, or to directly planarize the wafer surface by chemical mechanical polishing (see, for example, Patent Document 1). Semiconductor wafers may be repeatedly reclaimed and used until the thickness of the wafer falls below a given value. It is thus important to minimize the thickness of a semiconductor wafer removed during reclamation so as to increase the number of times that the wafer can be repeatedly reclaimed and used.

### PRIOR ART DOCUMENT

Patent Document 1: Japanese Laid-Open Patent Publication No. 2000-138192

### SUMMARY OF THE INVENTION

### Problems that the Invention is to Solve

It is therefore an objective of the present invention to provide a method for reclaiming semiconductor wafers that is capable of reclaiming a semiconductor wafer by planarizing the surface of the wafer at a smaller removal thickness by polishing. A further objective of the invention is to provide a polishing composition for use in such a method.

### Means for Solving the Problems

To achieve the foregoing objective and in accordance with one aspect of the present invention, a method for reclaiming a semiconductor wafer having a step of from 100 to 2,000 nm in height on a surface thereof by planarizing the wafer surface is provided. The planarization is carried out by polishing the surface of the semiconductor wafer with a polishing composition containing at least a step eliminating agent, which is adsorbed to the surface of the semiconductor wafer and acts to prevent etching of bottom portion of the step on the wafer surface during polishing.

The step eliminating agent is not subject to any particular limitation, provided it acts to prevent etching of the bottom portion of the step on the semiconductor surface. Illustrative examples of the step eliminating agent include water-soluble polymers such as polyvinyl alcohols, polyvinyl pyrrolidones, polyethylene glycols, and celluloses; and surfactants such as carboxylic acid surfactants, sulfonic acid surfactants, and phosphate ester surfactants. Preferred step eliminating agents include polyvinyl alcohol, polyvinyl pyrrolidone, hydroxyethyl cellulose, and polyoxyethylene polyoxypropylene glycol are preferred.

The polishing composition may additionally contain a basic compound, abrasive grains, or a pH adjuster. Preferred basic compounds include potassium hydroxide, potassium carbonate, tetramethylammonium hydroxide, and piperazine.

In accordance with another aspect of the present invention, a polishing composition used for polishing a semiconductor wafer surface having a step in order to planarize the wafer surface and thereby reclaiming the semiconductor wafer is provided. The polishing composition includes at least a step eliminating agent, which is adsorbed to the surface of the wafer and acts to prevent etching of bottom portion of the step on the wafer surface during polishing.

### Effects of the Invention

The invention thus provides a method for reclaiming semiconductor wafers that is capable of reclaiming a semiconductor wafer by planarizing the surface of the wafer at a smaller removal thickness by polishing. The invention also provides a polishing composition for use in such a method.

### MODES FOR CARRYING OUT THE INVENTION

One embodiment of the invention will be described below.

In the method for reclaiming semiconductor wafers of the present embodiment, which is carried out for the reuse of used test wafers, after films such as metal films and dielectric films on the semiconductor wafer have been removed from a used test wafer, the surface of the semiconductor wafer is subjected to chemical mechanical polishing using a polishing composition. Removal of the films on the semiconductor wafer is effected by dry etching or wet etching until the surface of the semiconductor wafer emerges. The surface of the semiconductor wafer following such film removal is not planar, typically having steps of 100 to 2,000 nm in height. These steps are due to the presence of recessed features having widths of, for example, 1,000 µm or less on the surface of the semiconductor wafer. In some cases, the cause of such steps is an intentional pattern that was formed by etching on a test wafer; in other cases, the steps are caused by unintentional scratches. The above-mentioned chemical mechanical polishing is carried out for the purpose of planarizing the surface of the semiconductor wafer following film removal, and more specifically for the purpose of reducing the height of steps on this surface to 20 nm or less.

The reclamation of semiconductor wafers is completed once the height of steps formed on the wafer surface due to causes such as those mentioned above has been reduced to a level that permits reuse of the semiconductor wafer. The height of the steps at the level permitting reuse of the semiconductor wafer varies with the reuse application, but is typically 30 nm or less, preferably 20 nm or less, and even more preferably 10 nm or less. The thickness of a semiconductor wafer required to be removed for reclamation depends on the initial height of the steps, and thus is not subject to any particular limitation, although it is typically 10,000 nm or less, preferably 5,000 nm or less, and more preferably 3,000 nm or less.

The polishing composition used herein includes at least a step eliminating agent that is adsorbed to the surface of a semiconductor wafer and acts to prevent etching of bottom portions of the steps on the wafer surface during polishing. Exemplary step eliminating agents include water-soluble polymers such as polyvinyl alcohols, polyvinyl pyrrolidones, polyethylene glycols, and celluloses; and surfactants such as carboxylic acid surfactants, sulfonic acid surfactants, and phosphate ester surfactants. The water-soluble polymers and surfactants are preferably nonionic or anionic. Polyvinyl alcohol, polyvinyl pyrrolidone and hydroxyethyl cellulose are especially preferred as the step eliminating agent. An oxyalkylene polymer having one or more types of oxyalkylene units may be used as the step eliminating agent. The use of polyoxyethylene polyoxypropylene glycol is preferred.

Several of these water-soluble polymers and surfactants are known to be used in finish polishing compositions for silicon wafers. Although such water-soluble polymers and surfactants are employed for the purpose of reducing the very fine, nanometer-order surface roughness of silicon wafers or for improving the wettability thereof, they are not used to eliminate steps. Moreover, when a finish polishing composition is used in the reclamation method of the present the invention, the silicon wafer polishing rate is very low, as a result of which polishing must be carried out for a long time until the steps are eliminated, which is impractical. At the same time, because a high polishing rate is required in primary polishing within the silicon wafer fabrication process, such water-soluble polymers and surfactants that act to lower the polishing rate are not used in primary polishing compositions for silicon wafers.

The average molecular weight of the polyvinyl alcohol used as the step eliminating agent is preferably at least 5,000. As the average molecular weight becomes higher, the polyvinyl alcohol acts more strongly to prevent etching of the bottom portions of the steps on the semiconductor wafer surface during polishing. Hence, when a polyvinyl alcohol having an average molecular weight of at least 5,000 is used, such etching is easily suppressed to a level that is especially desirable for practical purposes.

The average molecular weight of the polyvinyl alcohol used as the step eliminating agent is preferably 1,000,000 or less. As the average molecular weight of the polyvinyl alcohol used becomes lower, foaming of the polishing composition is less likely to arise, in addition to which a polyvinyl alcohol-induced decrease in the semiconductor wafer polishing rate by the polishing composition is suppressed. In this regard, using a polyvinyl alcohol having an average molecular weight of 1,000,000 or less is advantageous for obtaining a semiconductor wafer polishing rate by the polishing composition that is especially desirable for practical purposes.

For similar reasons, the average molecular weight of polyvinyl pyrrolidone used as the step eliminating agent is preferably at least 5,000 and less than 2,000,000; the average molecular weight of hydroxyethyl cellulose used as the step eliminating agent is preferably at least 100,000 and less than 2,000,000; the molecular weight of surfactant used as the step eliminating agent is preferably at least 100 and not more than 500,000; and the average molecular weight of polyoxyethylene polyoxypropylene glycol used as the step eliminating agent is preferably at least 300 and less than 50,000.

The content of the step eliminating agent in the polishing composition is preferably at least 0.001 g/L. In cases where polyvinyl alcohol is used as the step eliminating agent, the content of the step eliminating agent in the polishing composition is more preferably at least 0.02 g/L, and even more preferably at least 0.05 g/L. As the content of the step eliminating agent becomes higher, the bottom portions of the steps on the semiconductor wafer surface become less likely to undergo etching. Hence, in cases where the content of the step eliminating agent is at least 0.001 g/L or, if polyvinyl alcohol is used as the step eliminating agent, in cases where the content is at least 0.02 g/L, or even at least 0.05 g/L, etching of the bottom portions of the steps on the semiconductor wafer surface during polishing is easily held down to a level that is especially desirable for practical purposes.

The content of the step eliminating agent in the polishing composition is preferably 5 g/L or less, and more preferably 1.5 g/L or less. When polyvinyl alcohol is used as the step eliminating agent, the content of the step eliminating agent in the polishing composition is more preferably 1.5 g/L or less, and even more preferably 0.5 g/L or less. As the content of the step eliminating agent becomes lower, a decline in the semiconductor wafer polishing rate by the polishing composition owing to the influence of the step eliminating agent is suppressed. Hence, in cases where the content of the step eliminating agent is 5 g/L or less, or even 1.5 g/L or less, or, if polyvinyl alcohol is used as the step eliminating agent, in cases where the content is 1.5 g/L or less, or even 0.5 g/L or less, this is advantageous for obtaining a semiconductor wafer polishing rate by the polishing composition at a level that is especially desirable for practical purposes.

The polishing composition preferably contains also a basic compound that acts to chemically polish the semiconductor wafer. Illustrative examples of the basic compound include inorganic alkali compounds such as potassium hydroxide, sodium hydroxide, potassium bicarbonate, potassium carbonate, sodium bicarbonate, and sodium carbonate; ammonia; ammonium salts such as tetramethylammonium hydroxide, ammonium bicarbonate, and ammonium carbonate; amines such as piperazine, 1-(2-aminoethyl)piperazine, N-methylpiperazine, methylamine, dimethylamine, trimethylamine, ethylamine, diethylamine, triethylamine, ethylenediamine, monoethanolamine, N-(β-aminoethyl)ethanolamine, hexaethylenediamine, diethylenetriamine, and triethylenetetramine. Of these, potassium hydroxide, potassium carbonate, ammonia, tetramethylammonium hydroxide, and piperazine are preferred basic compounds; and potassium hydroxide, potassium carbonate, tetraethylammonium hydroxide, and piperazine are especially preferred.

The content of the basic compound in the polishing composition is preferably at least 0.1 g/L, and more preferably at least 0.2 g/L. As the content of the basic compound becomes higher, the semiconductor wafer polishing rate by the polishing composition rises.

The content of the basic compound in the polishing composition is preferably 10 g/L or less, and more preferably 8 g/L or less. As the content of the basic compound becomes lower, it becomes easier to control etching of the semiconductor wafer surface by the basic compound.

The polishing composition preferably contains also abrasive grains that act to mechanically polish the semiconductor wafer. Illustrative, non-limiting, examples of the abrasive grains include silica such as fumed silica and colloidal silica. Of these, colloidal silica is preferred.

The content of the abrasive grains in the polishing composition is preferably at least 0.1% by mass, and more preferably at least 0.3% by mass. As the content of the abrasive grains becomes higher, the semiconductor wafer polishing rate by the polishing composition rises.

The content of the abrasive grains in the polishing composition is preferably 20% by mass or less, and more preferably 10% by mass or less. As the content of the abrasive grains becomes lower, it becomes possible to hold down the material costs of the polishing composition.

The average particle size of the abrasive grains, as calculated from the BET specific surface area of the abrasive grains, is preferably at least 15 nm, and more preferably at least 20 nm. As the average particle size of the abrasive grains becomes larger, the semiconductor wafer polishing rate by the polishing composition rises.

The average particle size of the abrasive grains is preferably 200 nm or less, and more preferably 150 nm or less. As the average particle size of the abrasive grains becomes smaller, a surface roughness achieved after polishing of the semiconductor wafer with the polishing composition becomes lower.

The pH of the polishing composition is preferably from 9.0 to 12.0, and more preferably from 10.0 to 11.0. When the pH of the polishing composition is set in the above range, it is easy to obtain a polishing rate at an especially desirable level for practical purposes. A pH adjuster may be used to obtain the desired pH. It is also possible to use the basic compound described earlier as a pH adjuster.

The semiconductor wafer used in the reclamation method of the present embodiment is not subject to any particular limitation, provided it is a semiconductor wafer capable of serving as the substrate of a semiconductor device. Illustrative examples of semiconductors include silicon, germanium, and compound semiconductors (GaAs, InAs, GaN). Of these, silicon, germanium, and GaAs, which are easy to chemically etch, are preferred. The use of silicon is especially preferred.

The reclamation method of the present embodiment may be carried out using an ordinary polishing machine having a polishing platen to which a polishing pad has been attached. The polishing composition may be used in a "continuous flow process without circulation" that involves discarding the composition following use in polishing, or may be circulated and repeatedly used. An example of a method for the cyclic use of the polishing composition is a method in which used polishing composition discharged from the polishing machine is recovered in a tank, and the recovered polishing composition is again fed to the polishing machine. When the polishing composition is cyclically used, the amount of used polishing composition to be treated as waste declines compared with use in a "continuous flow process without circulation", enabling environmental impact to be reduced. Moreover, because the amount of polishing composition used decreases, the cost of reclaiming semiconductor wafers can be reduced.

When the polishing composition is cyclically used, the content of the step eliminating agent in the composition gradually decreases. Reasons for the decrease in the content of the step eliminating agent in the polishing composition include loss of the step eliminating agent due to washing of the polishing machine at the completion of a batch, dilution of the polishing composition due to the admixture of cleaning water, consumption of the step eliminating agent due to use in polishing, adhesion of the step eliminating agent to the polishing machine, polishing pads, and semiconductor wafers, and capture of the step eliminating agent by filters. Hence, when the polishing composition is cyclically used, it is preferable to suitably replenish the step eliminating agent during cyclic use in order to restore the content of the step eliminating agent in the polishing composition to the desired level.

Also, when the polishing composition is cyclically used, the pH of the polishing composition may be maintained within a given range, preferably from 9.0 to 12.0, and more preferably from 10.0 to 11.0, by suitably replenishing the pH adjuster during cyclic use.

The present embodiment provides the following advantages.

In the method for reclaiming semiconductor wafers of the present embodiment, in order to polish the surface of a semiconductor wafer that is to be reclaimed by planarization of the wafer surface, a polishing composition containing at least a step eliminating agent is used. In this case, owing to the action by the step eliminating agent that is adsorbed to the surface of the semiconductor wafer and suppresses the etching of bottom portions of the steps during polishing, portions of the steps other than the bottom portions, i.e., the top portions of the steps, are preferentially removed by polishing. As a result, the removal thickness by polishing required in order to reclaim a semiconductor wafer by planarizing the wafer surface can be made smaller. Specifically, it is possible to planarize the semiconductor wafer surface by polishing the surface to remove a thickness of not more than 20 times the height of the steps prior to polishing. Thus, when the height of the steps prior to polishing (initial steps) is 100 nm, the removal thickness by polishing required to planarize the surface of the semiconductor wafer is 2,000 nm or less. When the height of the steps prior to polishing is 2,000 nm, the removal thickness by polishing required is 40,000 nm or less.

The above embodiment may be modified as follows.

The polishing composition of the embodiment may contain two or more types of step eliminating agents.

The polishing composition of the embodiment may contain two or more types of basic compounds.

The polishing composition of the embodiment may contain two or more types of abrasive grains.

The polishing composition of the embodiment may further contain at least one type of chelating agent. When a chelating agent is contained, metal contamination of the semiconductor wafer is minimized. Exemplary chelating agents include aminocarboxylic acid chelating agents and organic phosphonic acid chelating agents. Examples of the aminocarboxylic acid chelating agents include ethylenediaminetetraacetic acid, sodium ethylenediaminetetraacetate, nitrilotriacetic acid, sodium nitrilotriacetate, ammonium nitrilotriacetate, hydroxyethylethylenediaminetriacetic acid, sodium hydroxyethylethylenediaminetriacetate, diethylenetriaminepentaacetic acid, sodium diethylenetriaminepentaacetate, triethylenetetraaminehexaacetic acid, and sodium triethylenetetraaminehexaacetate. Examples of the organic phosphonic acid chelating agents include 2-aminoethylphosphonic acid, 1-hydroxyethylidene-1,1-diphosphonic acid, aminotri(methylenephosphonic acid), ethylenediamine tetrakis(methylene phosphonic acid), diethylenetriamine penta(methylene phosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methanehydroxyphosphonic acid, 2-phosphonobutane-1,2-dicarboxylic acid, 1-phosphonobutane-2,3,4-tricarboxylic acid, and α-methylphosphonosuccinic acid. Of these, preferred chelating agents are triethylenetetraaminehexaacetic acid, diethylenetriaminepentaacetic acid, ethylenediamine tetrakis(methylene phosphonic acid), and diethylenetriamine penta(methylene phosphonic acid). Ethylenediamine tetrakis(methylene phosphonic acid) and triethylenetetraaminehexaacetic acid are especially preferred.

The polishing composition of the embodiment may be prepared by diluting stock slurry of the polishing composition with water.

The polishing composition of the embodiment may be a one-component composition or may be a multi-component composition such as a two-component composition. For example, the polishing composition may be prepared by mixing a first component, which contains water and at least one ingredient from among the step eliminating agent, the basic compound, and the abrasive grains in combination, with a second component, which contains at least water and the ingredient from among the step eliminating agent, the basic compound, and the abrasive grains that is not contained in the first component. More specifically, the polishing composition may be prepared by mixing together a first component containing the step eliminating agent, the basic compound, and water with a second component containing the abrasive grains and water. Alternatively, the polishing composition may be prepared by mixing together a first component containing water and at least one ingredient from among the basic compound and the abrasive grains with a second component containing water and the step eliminating agent. Preparation of the polishing composition may be carried out by separately feeding the first and second components to the same polishing machine, and thereby mixing the first and second components in the polishing machine.

In cases where the polishing composition is circulated and repeatedly used, in place of the step eliminating agent or in addition to the step eliminating agent, ingredients other than the step eliminating agent in the polishing composition, such as at least one of the basic compounds, abrasive grains, pH adjusters, and chelating agents, may be suitably replenished so as to restore the contents of these ingredients in the polishing composition to their desired levels. In cases where a plurality of the ingredients included in the polishing composition are replenished, replenishment of the plurality of ingredients may be carried out separately or may be carried out in the form of a mixture in which the plurality of ingredients have been mixed in any suitable proportion. That is, by suitably adding a mixture of the step eliminating agent and the pH adjuster to the polishing composition during cyclic use, the diminished content of the step eliminating agent in the polishing composition may be restored to the desired level and, at the same time, the pH of the polishing composition may be maintained within a predetermined range. Alternatively, replenishment of one or a plurality of ingredients in the polishing composition during cyclic use may be carried out by suitably adding, to the polishing composition, a dilution that contains in any concentration the ingredients to be replenished. In cases where the concentration within the dilution of an ingredient to be replenished has been elevated, this has the advantage that replenishment of the ingredient can be adequately carried out even with the addition of only a small amount of the dilution. On the other hand, in cases where the concentration within the dilution of an ingredient to be replenished has been lowered, this has the advantage that the amount of the dilution added can be easily adjusted according to the amount of the ingredient that is to be replenished.

The method for reclaiming semiconductor wafers of the embodiment is not limited to being carried out for the purpose of reusing used test wafers, and may also be carried out for the purpose of reusing prime wafers that are defective.

Next, examples of the invention and comparative examples are described below.

The polishing compositions in Examples 1 to 18 and in Comparative Examples 1 to 5 were prepared by mixing some or all of the following with water: colloidal silica as the abrasive grains, the basic compound, and the step eliminating agent. The polishing compositions were all adjusted to a pH of 10.5. Details of the colloidal silica, the basic compound, and the step eliminating agent contained in each of the polishing compositions in Examples 1 to 18 and Comparative Examples 1 to 5 are as shown in Table 1. The average primary particle sizes of the colloidal silicas shown in Table 1 were measured with a surface area measuring device available from Micromeritics under the trade name FlowSorb II 2300. The average molecular weights of the step eliminating agents shown in Table 1 are weight-average molecular weights. In the "Basic compound" column of Table 1, "PIZ" stands for piperazine, "TMAH" stands for tetramethylammonium hydroxide, "KOH" stands for potassium hydroxide, and "K₂CO₃" stands for potassium carbonate. In the "Step eliminating agent" column in Table 1, "PVA" stands for polyvinyl alcohol, "HEC" stands for hydroxyethyl cellulose, "POE-POP" stands for polyoxyethylene polyoxypropylene glycol, and "PVP" stands for polyvinyl pyrrolidone.

Using the respective polishing compositions prepared in Examples 1 to 18 and Comparative Examples 1 to 5, silicon wafers having initial steps with a height of 230 nm were polished under the conditions indicated in Table 2. Polishing was carried out until steps on the surface of the silicon wafer could no longer be observed on a differential interference contrast (DIC) map obtained using a surface defect detector "SP2" from KLA-Tencor Japan, Ltd. On a DIC map, only steps having a height exceeding 20 nm are observed. That is, at a step height obtained from polishing of 20 nm or below, it becomes impossible to find the steps on a DIC map. The removal thickness by polishing and the polishing time required until steps can no longer be observed are shown in the "Evaluation" column in Table 1.

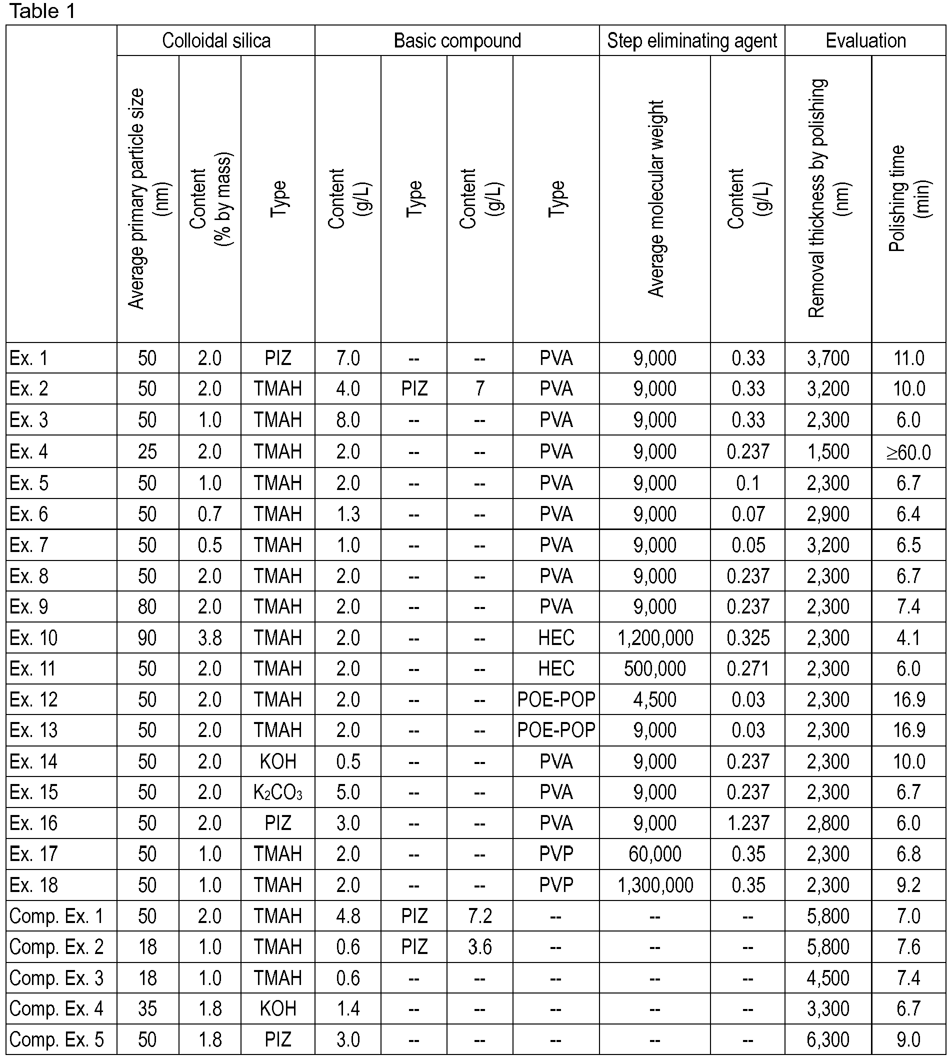

**Table 2**

| | |
|---|---|
| Polishing machine: | Single-wafer polishing machine PNX-322 made by Okamoto Machine Tool Works, Ltd. |
| Polishing load: | 250 g/cm² |
| Revolution of platen: | 50 rpm |
| Feed rate of polishing composition: | 550 mL/min |

As shown in Table 1, when the step eliminating agent-containing polishing compositions of Examples 1 to 18 were used, it was possible to planarize the surface of a silicon wafer by a smaller removal thickness by polishing than when polishing compositions of Comparative Examples 1 to 5 containing no step eliminating agent were used.

## Claims

1. A method for reclaiming a semiconductor wafer having a step on a surface thereof by planarizing the wafer surface,
the method being **characterized in that** the planarization is carried out by polishing the surface of the semiconductor wafer with a polishing composition containing at least a step eliminating agent, which is adsorbed to the surface of the semiconductor wafer and acts to prevent etching of bottom portion of the step on the wafer surface during polishing.

2. The method according to claim 1, wherein the step eliminating agent is a water-soluble polymer or a surfactant.

3. The method according to claim 1 or 2, wherein the step eliminating agent is a polyvinyl alcohol, a polyvinyl pyrrolidone, a polyethylene glycol, a cellulose, a carboxylic acid surfactant, a sulfonic acid surfactant, a phosphate ester surfactant, or an oxyalkylene polymer.

4. The method according to any one of claims 1 to 3, wherein the step eliminating agent is polyvinyl alcohol, polyvinyl pyrrolidone, hydroxyethyl cellulose, or polyoxyethylene polyoxypropylene glycol.

5. The method according to any one of claims 1 to 4, wherein the step eliminating agent is contained in the polishing composition in an amount of from 0.001 to 5 g/L.

6. The method according to any one of claims 1 to 5, wherein the polishing composition additionally contains a basic compound.

7. The method according to claim 6, wherein the basic compound is potassium hydroxide, potassium carbonate, tetramethylammonium hydroxide, or piperazine.

8. The method according to any one of claims 1 to 7, wherein the polishing composition additionally contains abrasive grains.

9. The method according to any one of claims 1 to 8, wherein the polishing composition has a pH of from 9.0 to 12.0.

10. The method according to any one of claims 1 to 9, wherein the polishing composition additionally contains a pH adjuster.

11. The method according to any one of claims 1 to 10, wherein the step has a height of from 100 to 2,000 nm.

12. The method according to any one of claims 1 to 11, wherein the surface of the semiconductor wafer is planarized by polishing the surface to remove a thickness of not more than 20 times the height of the step.

13. The method according to any one of claims 1 to 12, wherein the semiconductor wafer is a silicon wafer.

14. The method according to any one of claims 1 to 13, wherein the polishing composition is prepared by mixing together a first component and a second component, the first component containing, together with water, at least one ingredient selected from the group consisting of a step eliminating agent, a basic compound, and abrasive grains, and the second component containing at least water and one or more ingredients selected from the group consisting of a step eliminating agent, a basic compound, and abrasive grains that are not contained in the first component.

15. The method according to claim 14, wherein the first component contains, together with water, at least one of a basic compound and abrasive grains, the second component contains a step eliminating agent and water, and preparation of the polishing composition is carried out by separately feeding the first component and the second component to a polishing machine and mixing the first and second components in the polishing machine.

16. The method according to any one of claims 1 to 15, wherein the polishing composition is circulated and repeatedly used.

17. The method according to claim 16, wherein during circulating and repeated use of the polishing composition, the pH of the polishing composition is adjusted within a range of 9.0 to 12.0 by replenishing the polishing composition with a pH adjuster.

18. The method according to claim 16 or 17, wherein during circulating and repeated use of the polishing composition, the polishing composition is replenished with at least one ingredient selected from the group consisting of a step eliminating agent, a basic compound, and the abrasive grains.

19. A polishing composition used for polishing a semiconductor wafer surface having a step in order to planarize the wafer surface and thereby reclaiming the semiconductor wafer,
the composition being **characterized by** at least a step eliminating agent, which is adsorbed to the surface of the wafer and acts to prevent etching of bottom portion of the step on the wafer surface during polishing.
